# EUROPÄISCHE PATENTSCHRIFT

(11) **EP 0 527 330 B1**
(45) Veröffentlichungstag und Bekanntmachung des Hinweises auf die Patenterteilung: **28.02.1996**
(21) Anmeldenummer: 92111544.0
(22) Anmeldetag: 08.07.1992
(51) Int. Cl.: H05K 7/18

(54) **Verteilerschrank der Kommunikationstechnik**
Distribution cabinet for communications technology
Armoire de distribution pour la technique de communication

(30) Priorität: 10.08.1991 DE 9109927 U
(43) Veröffentlichungstag der Anmeldung: 17.02.1993
(73) Patentinhaber: QUANTE AG, D-42109 Wuppertal (DE)
(72) Erfinder: Wetzels, Ralf Dipl.-Phys., W-5609 Hückeswagen (DE); Höschler, Peter H.Dipl.-Ing., W-5620 Velbert 1 (DE); Weckner, Peter H., W-5600 Wuppertal 2 (DE); Lutterkordt, Ulrich H. Dipl.-Ing., W-5600 Wuppertal (DE)
(74) Vertreter: Mentzel, Norbert, Dipl.-Phys.

(56) Entgegenhaltungen:
- DE-A- 3 300 066
- DE-U- 8 511 217
- FR-A- 2 589 291

## Beschreibung

Zur übersichtlichen Unterbringung und Bedienung von Kabelabschluß- und Rangiermitteln werden Standschränke für Kabel mit größerer Aderpaarzahl verwendet, während bei kleineren Aderpaarzahlen Wandverteilergehäuse benutzt werden. Der Einfachheit wegen sollen diese Behältnisse nachfolgend kurz "Schränke" genannt werden. Aus Gründen einer sachgerechten Kabelführung werden ankommende Kabel aus Fußbodenkanälen od. dgl. von unten durch die Bodenwand des Schrankes eingeführt, während das abgehende Kabel durch die Dachwand des Schrankes abgeführt wird und zu oberhalb des Schrankes angeordneten Kabelrosten führt. Je nach Art der Kabelabschluß- und Rangiermittel einerseits und der gegebenen Mindestbiegeradien der verwendeten Kabel andererseits bedarf es unterschiedlicher Schranktiefen und die zum Ein- bzw. Abführen der Kabel erforderlichen Wandöffnungen im Schrank müssen dementsprechend unterschiedliche Lagen einnehmen und unterschiedliche Öffnungsweiten aufweisen. Dies Wandöffnungen müssen dem jeweiligen Anwendungsfall möglichst genau angepaßt sein, um Staubeintritt in den Schrank zu verhindern. Andernfalls werden die Isolationswiderstände der elektrischen Kontakte an den Kabelabschluß- und Rangiermitteln gemindert und die Funktionen der angeschlossenen Geräte gestört.

Aus DE-U-8 511 217 ist ein Verteilerschrank bekannt, wobei im Boden und Deckteil abschließbare Ausnehmungen zur Durchführung elektrischer Leitungen angeordnet sind.

Eine werkseitig genaue Lage und Größe der Wandöffnungen läßt sich nicht verwirklichen, sofern man nicht eine unübersichtliche Vielzahl unterschiedlicher Schranktypen bereit hält. In der bisherigen Praxis wurde am Aufstellungsort der Schränke die boden- bzw. dachseitige Schrankwand bearbeitet, wofür man dort leicht zu bearbeitende Materialien aus Holz, Gummi oder Kunststoff verwendete. Dies erforderte jedoch einen größeren handwerklichen Aufwand am Aufstellungsort. Derartige leicht zu bearbeitende Materialien gefährdeten auch die Festigkeit und Sicherheit des Gehäuses, das aus Sicherheitsgründen aus korrosionsgeschütztem Stahlblech hergestellt wird. Oftmals wird ein solcher Schrank im Übermaß gekauft mit dem Ziel, ihn beim künftigen Bedarf durch Ein- und/oder Abführung zusätzlicher Kabel zu vervollständigen. Bei diesem Vollausbau des Schrankes ist es erforderlich, die Weite der Einfhrungsöffnung nachträglich entsprechend zu vergrößern. Dazu mußte bisher die vorhandene Wandöffnung nachgeschnitten werden, was wegen der bereits früher verlegten Kabel schwierig war. Sofern man von vorneherein eine zu groß bemessene Wandöffnung verwendete, mußte diese im Anfangsfall durch Leisten mit Stopfbuchsen od. dgl. mühsam verengt werden.

Der Erfindung liegt die Aufgabe zugrunde, einen preiswerten, zuverlässigen Schrank der im Anspruch 1 gegebenen Art zu entwickeln, bei dem die Wandöffnung hinsichtlich ihrer Lage in der boden- und/oder deckenseitigen Schrankwand und/oder die Öffnungsweite der Wandöffnung am Aufstellungsort schnell und bequem den jeweiligen Bedürfnissen angepaßt werden können. Dies wird erfindungsgemäß durch die im Kennzeichen des Anspruches 1 angeführten Maßnahmen erreicht, denen folgende besondere Bedeutung zukommt.

Werkseitig wird die zum Ein- bzw. Ausführen von Kabeln dienende Schrankwand mit einem so großen Fenster versehen, daß innerhalb des Fensters die gesamte Palette der diversen Lagen und Größen der Wandöffnungen liegt, die bei den verschiedenen Anwendungsfällen zu erwarten sind. Die im Anwendungsfall nicht benötigten Bereiche des Fensters werden von Platten abgedeckt, die in Führungen parallel zur Schrankwand verstellbar sind. In Abhängigkeit von der jeweils benötigten Lage der Wandöffnung und/oder ihrer Öffnungsweite werden die Platten in den Führungen verstellt. Die Platten können, wie die Schrankwand selbst, aus massivem Stahlblech bestehen, das am Aufstellungsort nicht bearbeitet zu werden braucht und dem Schrank eine stabile zuverlässige Form gibt. Zur Auswahl der Lage und Weite der Wandöffnung bedarf es lediglich einer Verstellung der Platten, deren Verstellrichtung durch die Führungen gesteuert wird.

Diese Verstellungen sind am Aufstellungsort bequem und schnell auch bei nachträglicher Ergänzung mit Kabeln vollziehbar. Die Endposition der die Wandöffnung begrenzenden Platten kann nach ihrer Einstellung bedarfsweise fixiert werden. Bearbeitungen der Schrankwände am Aufstellungsort entfallen. Man kann einen Schrank gegebener Type hinsichtlich Lage und Weite seiner Wandöffnungen innerhalb eines großen Bereichs variieren. Herstellung und Lagerhaltung lassen sich daher auf wenige Typen unterschiedlicher Schrankgesamttiefe reduzieren.

Es empfiehlt sich insbesondere Längsführungen in Erstreckungsrichtung des Fensters anzuordnen, wo eine Schar von Platten linear einzel- oder gruppenweise verstellbar sind, was in den Unteransprüchen näher ausgeführt ist. Die Platten können dabei entweder in zueinander höhenversetzten Parallelebenen liegen oder aber höhengleich angeordnet sein, um sie bedarfsweise zu einer gemeinsam verschiebbaren Kombinationsplatte zu kuppeln. Anstelle von Längsführungen könnte man auch Drehführungen für schwenkbewegliche Platten verwenden. Als weitere Alternative könnte man zueinander richtungsunterschiedlich bewegliche Platten ein gemeinsames Fenster abdecken lassen, wodurch sich die Variationsvielfalt der Lage und Weite der gewünschten Wandöffnungen weiter variieren läßt.

Weitere Maßnahmen und Vorteile der Erfindung ergeben sich aus den Unteransprüchen, der Beschreibung und den Zeichnungen, wo die Erfindung in zwei Ausführungsbeispielen dargestellt ist. Es zeigen:

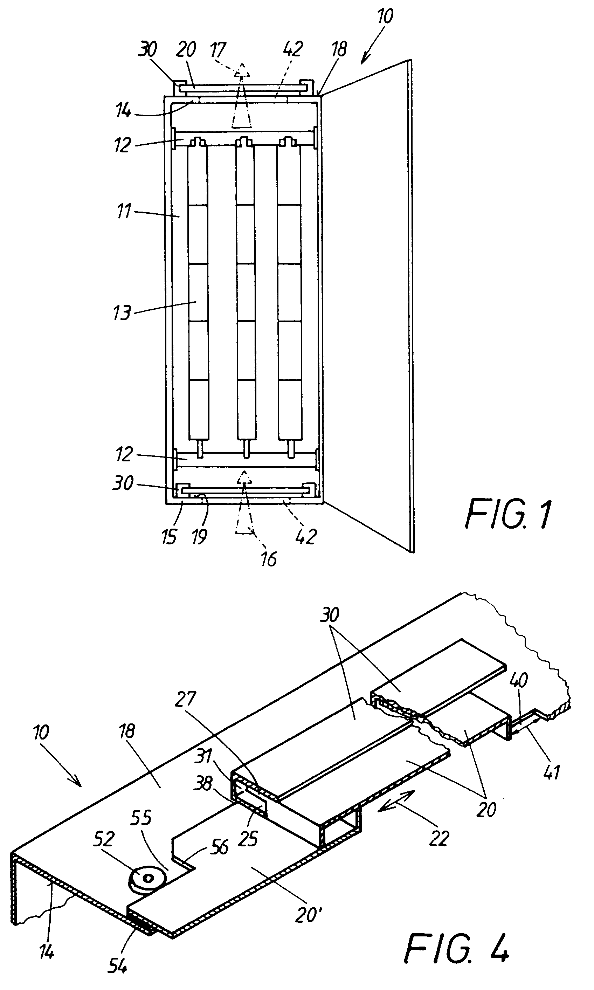

- Fig. 1: die schematische Vorderansicht auf einen geöffneten Schrank nach der Erfindung,
- Fig. 2: in perspektivischer, teilweise ausgebrochener Darstellung, die deckenseitige Wand des Schrankes von Fig. 1,
- Fig. 3: in einer perspektivischen Explosionsdarstellung und im Ausbruch die Bestandteile einer deckenseitigen Wand einer zweiten Ausführungsform des Schrankes und
- Fig. 4: im Ausbruch weitere Details der in Fig. 3 gezeigten Schrankwand nach ihrer Montage.

Der Schrank 10 besitzt in seinem Schrankinneren 11 waagerecht oder senkrecht verlaufende Montageschienen 12, an denen die erwünschten Kabelabschluß- und Rangiermittel 13 sitzen. An der deckenseitigen sowie bodenseitigen Schrankwand 14, 15 werden, wie durch Pfeile 16, 17 verdeutlicht, nicht näher gezeigte Kabel ins Schrankinnere 11 eingeführt bzw. ausgeführt, um mit ihren Adern an den Einrichtungen 13 kontaktiert zu werden. Dazu ist die Außenseite 18 der deckenseitigen Wand 14 und/oder die Innenseite 19 der bodenseitigen Wand 15 des Schrankes 10 mit besonderen Einrichtungen 20, 30 versehen, welche variable Wandöffnungen 40 der jeweiligen Bedürfnisse herstellen und hinsichtlich ihrer Öffnungsweite 41 anzupassen gestatten. Da die Einrichtungen an beiden Schrankwänden 14, 15 übereinstimmend ausgebildet sind, genügt es, lediglich eine davon näher zu beschreiben.

Dazu ist die Schrankwand 14 mit einem Fenster 42 versehen, dessen Fensterlänge 43 sich über den ganzen Wandbereich erstreckt, in welchem in den verschiedenen Anwendungsfällen des Schrankes 10 jeweils eine Wandöffnung 40 erwünscht ist. Dieses Fenster 42 wird von einer Schar von Platten 20, 20' abgedeckt, die in einer Reihe zueinander angeordnet sind, aber vorzugsweise die gleiche Grundform aufweisen. Diese Platten 20, 20' sind mit ihren beiden einander gegenüberliegenden Randzonen 21 in besonderer Weise an zwei U-Profilschienen 30 längsverschiebbar im Sinne der Pfeile 22, 22' angeordnet. Die beiden U-Profilschienen 30 schließen zwischen sich das Fenster 42 ein und sind in Richtung des Fensterverlaufs 43 orientiert. Die U-Profilschiene 30 besitzt Schienenschenkel 32, 33 mit zueinander unterschiedlicher Schenkellänge. Der kürzere Schienenschenkel 32 ist der Schrankwand 14 zugekehrt, während der lange Schenkel 33 schauseitig darüberliegend angeordnet ist. Die an der U-Profilschiene gleitgeführten Platten 20, 20' haben folgenden übereinstimmenden Aufbau.

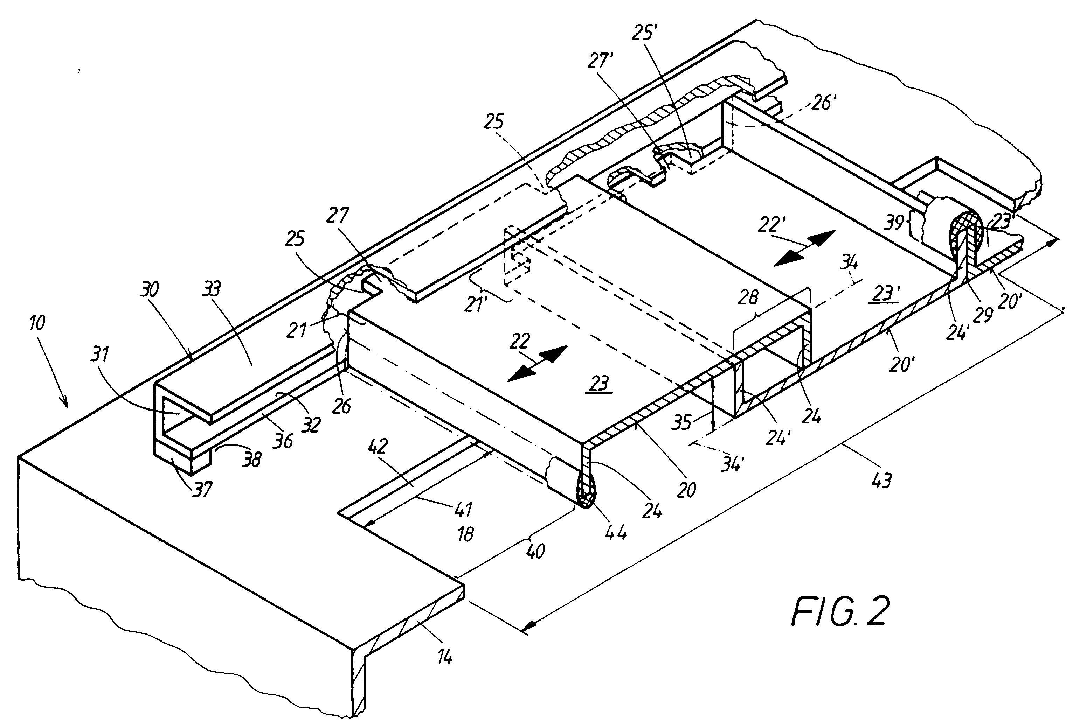

Alle Platten 20, 20' sind U-förmig verkröpft. Die am Plattenmittelstück 23 bzw. 23' jeweils abgewinkelten beiden Endstücke 24 bzw. 24' sollen nachfolgend kurz "Endflansche" bezeichnet werden. Die in der Reihenanordnung von Fig. 2 befindliche erste und zweite Platte 20, 20' sind in zueinander spiegelbildlicher Weise in den beiden U-Profilschienen 30 angeordnet, und zwar ist die erste Platte 20 mit ihren Endflanschen 24 abwärts, gegen die Schrankwand 14 gerichtet, während die Endflansche 24' der zweiten Platte 20' nach oben weisen, also von der Schrankwand 14 weggerichtet sind. Dadurch sind die das wesentliche Teilstück der Platte bestimmenden Mittelstücke 23, 23' in zwei zueinander höhenversetzten Parallelebenen 34, 34' angeordnet, wie durch die Strichpunktlinien in Fig. 2 veranschaulicht ist. Dieser Höhenversatz 35 entspricht der Flanschlänge. Die beiden Randzonen der verkröpften Platten 20, 20' sind im Bereich ihrer Endflansche 24 bzw. 24' jeweils mit Ausschnitten 25, 25' versehen, deren Ausschnittgrund 26, 26' die Endflansche 24, 24' randseitig begrenzt. Die Tiefe des Ausschnitts 25, 25' ist dabei so bemessen, daß der Ausschnittgrund 26, 26' jeweils an der Stirnkante 36 des kurzen Schienenschenkels 32 anliegt und daher bei der erwähnten Längsverschiebung 22, 22' dort seine Längsführung erfährt.

Zwischen den beiden endflanschseitigen Ausschnitten 25 verbleiben Lappen 27 bzw. 27' in den Plattenrandzonen 21 bzw. 21', welche in zueinander unterschiedlicher Weise mit den U-Profilschienen 30 zusammenwirken. Wie aus Fig. 2 ersichtlich, ist die U-Profilschiene 30 über einen Abstandhalter 37 an der Schrankwand 14 befestigt, weshalb zwischen der Schiene 30 und der Schrankwand 14 eine Lücke 38 verbleibt. Bei der eine Abdeckung in der oberen Ebene 34 bewirkenden Platte 20 greift der Lappen 27 ins Schieneninnere 31 ein. Bei der anderen Platte 20', die in der unteren Ebene 34' gemäß dem Pfeil 22' längsverschiebbar ist, greift der entsprechende Lappen 27' dagegen in die unterhalb der U-Profilschiene 30 befindlichen Lücke 38 ein. Die vorbeschriebenen Führungen 26, 36 bzw. 26', 36 werden durch den bereits erwähnten langen Schienenschenkel 33 schauseitig abgedeckt. Die untere Platte 20' befindet sich mit ihrem Plattenmittelstück 23' in Berührung mit der erwähnten Außenseite 18 der Schrankwand 14. Die lichte Weite der Lücke 38 entspricht der Plattenstärke der Platten 20, 20', weshalb in der Führung der beiden Platten 20, 20' sich ein Höhenversatz ergibt, der gleiche Flanschlängen der Endflansche 24, 24' zu verwenden gestattet. Die eine Platte 20 kann somit einfach durch gewendete Montage aus der anderen Platte 20' erzeugt werden. Beide Platten haben die gleiche Verkröpfung und vorzugsweise auch die gleiche Form.

Beide Platten 20, 20' sind zwar voneinander unabhängig längsverschiebbar 22, 22', doch geschieht diese Verstellung miteinander abgestimmt. Die Verschiebung 22, 22' erfolgt richtungsmäßig in Abhängigkeit davon, an welcher Stelle eine Wandöffnung 40 entstehen soll und das Ausmaß der Verschiebung 22, 22' bestimmt dabei die Öffnungsweite 41. Dementsprechend überlappen sich die beiden Platten 20, 20' mit ihren Plattenmittelstücken 23, 23', wodurch sich ein variabler Überlappungsabschnitt 28 gemäß Fig. 2 ergibt. Der hintere Endflansch 24 der ersten Platte 20 hintergreift dabei den vorderen Endflansch 24' der zweiten Platte 20. Die Endflansche 24, 24' sind zueinander gegensinnig abgewinkelt. Wird die eine Platte 20 gegen die andere Platte 20' verschoben, so entfernen sich die beiden Flansche 24, 24' voneinander. Bei einer aufeinander zu entgerichteten Bewegung wirken die beiden Flansche 24, 24' als Anschlag. Sofern die unbewegte Platte nicht festgehalten wird, fungieren die beiden Endflansche 24, 24' von da ab als Mitnehmer und führen zu einer gemeinsamen Bewegung der beiden Platten 20, 20'. Der vorderste Steg 24 der ersten Platte 20 ist dabei mit einem als Kantenschutz dienenden Einfaßsteg 44 versehen, der im Ausführungsbeispiel von Fig. 2 mit der Außenseite 18 der Schrankwand 14 in Berührung steht und daher zugleich ein Verkratzen der Wand verhindert.

Wie aus Fig. 2 weiter ersichtlich ist, sind in der Reihenanordnung der Platten hinter der beschriebenen zweiten Platte 20' noch eine weitere dritte Platte 20' angeordnet, die mit ihrem entsprechenden Mittelstück 23' in der gleichen unteren Parallelebene 34' wie dasjenige der zweiten Platte 20' angeordnet ist. Die beiden Platten 20' berühren sich mit den einander zugekehrten Stoßkanten 29, welche die Eckpunkte der abgewinkelten Endflansche 24' bestimmen. Die Berührungslage dieser Stoßkanten 29 kann durch einen Verbinder 45 gesichert werden. Dieser besteht aus einem elastischen Einfaßsteg, der eine feste Kupplung der beiden Platten 20' erzeugt und sie zu einer gemeinsam im Sinne des Längsverschiebungspfeils 22' beweglichen Kombinationsplatte vereinigt. Der elastische Steg 45 übergreift die Kantenstreifen 39 an den beiden Endflanschen 24'. Der Einfaßsteg 45 kann aber auch abgenommen werden, wodurch die Kombinationsplatte wieder in ihre beiden Einzelplatten 20' getrennt ist. Diese Platten 20' lassen sich nun wahlweise voneinander weg verschieben, wodurch dann zwischen ihnen eine nicht näher in Fig. 2 gezeigte Wandöffnung entsteht, deren lichte Weite wieder von dem gewählten Verschiebungs-Weg abhängt.

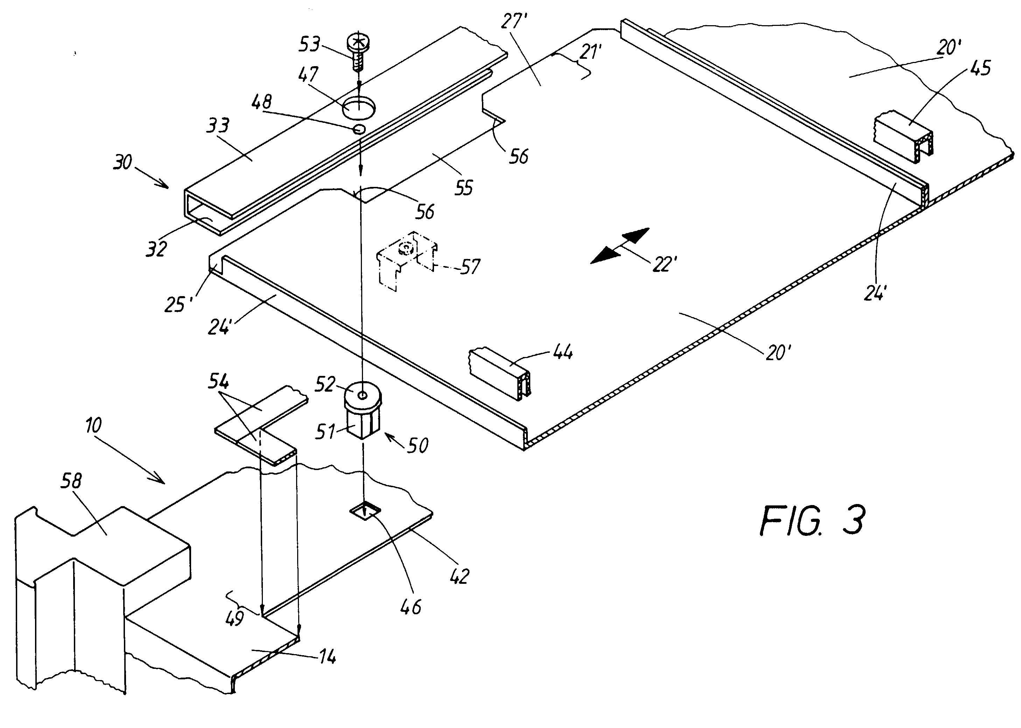

In Fig. 3 und 4 ist eine alternative Ausbildung des Schranks 10 dargestellt. Zur Bezeichnung entsprechender Bauteile sind die gleichen Bezugszeichen wie im ersten Ausführungsbeispiel verwendet, weshalb insoweit zunächst die bisherige Beschreibung gilt. Es genügt, lediglich auf die Unterschiede einzugehen.

In diesem Ausführungsbeispiel ist ein Abstandhalter 52 mit einem Spreizdübel 50 kombiniert, der zugleich zur Befestigung der U-Profilschiene 30 an der Schrankwand 14 dient. Dazu besitzt die Schrankwand 14 Vierkantlöcher 46, die von Spreizteilen 51 des Dübels 50 durchgriffen werden. Ferner besitzt der Dübel 50 einen endseitigen, kopfartig verdickten Bund 52, der die Funktion eines Abstandhalters für die U-Profilschiene 30 übernimmt. Die Montagelage des Spreizdübels 50 ist in Fig. 4 erkennbar, allerdings bei teilweise weggeschnittener U-Profilschiene und noch nicht gesetzter Befestigungsschraube 53. Diese Schraube 53 durchgreift nämlich, wie aus Fig. 3 ersichtlich ist, im Montagefall einen Durchbruch 47 im langen Schienenschenkel 33, wodurch der Schraubenkopf in Anlage an der Innenfläche des kurzen Schienenschenkels 32 kommt, der mit einer in Fig. 3 angedeuteten Bohrung 48 versehen ist. Die Befestigungsschraube 53 drückt die Spreizteile 51 des Dübels 50 auseinander.

Eine weitere Besonderheit dieses zweiten Ausführungsbeispiels besteht darin, daß der Randbereich 49 des Fensters 42, wie aus Fig. 3 und 4 hervorgeht, mit einer umlaufenden Flachdichtung 54 versehen ist, die an der Außenfläche 18 der Wand 14 haftet und auf welcher, gemäß Fig. 4, die nach oben verkröpften Platten 20' aufliegen. Dadurch ist der Schrank gegenüber Spritzwasser od. dgl. abgedichtet.

Eine weitere Besonderheit besteht darin, daß die verkröpften Platten 20 bzw. 20' im mittleren Bereich ihrer Randzonen 21 bzw. 21' mit einem Ausbruch 55 versehen sind. Dieser dient bei der aus Fig. 3 ersichtlichen unteren Platte 20' dazu, um in diesem Bereich den Abstandhalter-Dübel 50 an der U-Profilschiene 30 setzen zu können. Zugleich dienen aber die Ausbruchsenden 56 dazu, um mit dem Bund 52 dieses Abstandhalter-Dübels 50 anschlagartig zusammenzuwirken. Dadurch ist der Maximale Verschiebungsweg 22' dieser Platten 20' festgelegt. Die montierten Platten 20' sind nach ihrer Montage unverlierbar mit dem Schrank verbunden.

Im zweiten Ausführungsbeispiel ist schließlich auch der nach oben weisende Endflansch 24' der in der unteren Ebene verlaufenden verkröpften Platte 20' mit einem als Kantenschutz fungierenden Einfaßsteg 44 versehen. Die Montage der Schrankbestandteile erfolgt dabei in folgender Weise. Wenn eine vollkommen geschlossene Schrankwand 14 erwünscht ist, so können die Platten 20', wie Fig. 3 veranschaulicht, mit ihren nach oben weisenden Endschenkeln 24' aufgelegt und in der bereits beschriebenen Weise über den kuppelnden Einfaßsteg 45 miteinander zu einer umfassenden Kombinationsplatte verbunden werden. Nach dem Auflegen der Platten 20' auf die Flachdichtungen 54 längs des Fensters 42 werden nun mittels der Abstands-Dübel 50 die U-Profilschienen 30 befestigt. Die Lappen 27' greifen dabei in die Lücke 38. Wenn erwünscht, können diese Platten 20' durch entsprechend starken Anzug der Befestigungsschraube 53 und knappe Bemessung der Lücke 38 sogar klemmend von den Profilschienen 30 festgehalten werden. Will man nun eine variable Wandöffnung 40 an einer bestimmten Stelle einrichten, so wird die betreffende Paltte 20' gewendet und, wie Fig. 4 veranschaulicht, in eine mit ihren Endflanschen 24' nach unten weisende Platte 20 umgewandelt. Diese wird nun in der bereits beschriebenen Weise mit ihren Lappen 27 in das Schieneninnere 31 eingeführt und ist in der U-Profilschiene 30 zur Einstellung einer variablen Öffnungsweite 41 im Sinne des Pfeils 22 längsverschiebbar.

Wie aus Fig. 3 hervorgeht, sind auf der dem Fenster zugekehrten Innenfläche der Platten 20' Erdungsanschlüsse 57 vorgesehen, an denen Erdverbindungskabel angeschlossen werden, die von einer Platte 20' zur anderen verlaufen. Die Erdverbindungskabel sind schließlich zu einem Schrankeckpunkt geführt, der in Fig. 3 durch einen Eckpfosten 58 des Schranks veranschaulicht ist.

### Bezugszeichenliste:

- 10: Schrank
- 11: Schrankinneres
- 12: Montageschiene
- 13: Kabelanschlußmittel
- 14: deckseitige Schrankwand
- 15: bodenseitige Schrankwand
- 16: Kabel-Einführ-Pfeil
- 17: Kabel-Ausführ-Pfeil
- 18: Außenseite von 14
- 19: Innenseite von 15
- 20, 20': Platte
- 21, 21': Randzone von 20, 20'
- 22, 22': Längsverschiebungs-Pfeil von 20, 20'
- 23, 23': Plattenmittelstück von 20, 20'
- 24, 24': Endflansche von 20, 20'
- 25, 25': Ausschnitt in 20, 20'
- 26, 26': Ausschnittgrund von 25, 25'
- 27, 27': Lappen
- 28: Überlappungsabschnitt von 20, 20'
- 29: Stoßkante von 20'
- 30: Führung, U-Profilschiene
- 31: Schieneninneres
- 32: kurzer Schienenschenkel
- 33: langer Schienenschenkel
- 34, 34': Parallelebene von 23, 23'
- 35: Höhenversatz zwischen 23, 23'
- 36: Stirnkante von 32
- 37: Abstandhalter zwischen 14, 30
- 38: Lücke zwischen 14, 30
- 39: Kantenstreifen von 24'
- 40: variable Wandöffnung
- 41: Öffnungsweite von 40
- 42: Fenster in 14
- 43: Fensterlänge von 42
- 44: Einfaßsteg von 24
- 45: Verbinder, kuppelnder Einfaßsteg von 24'
- 46: Vierkantloch
- 47: Durchbruch in 33
- 48: Bohrung in 32
- 49: Randbereich von 42
- 50: Abstandhalter, Spreizdübel
- 51: Spreizteil von 50
- 52: Bund von 50
- 53: Befestigungsschraube für 50
- 54: Flachdichtung
- 55: Ausbruch in 21'
- 56: Ausbruchsende von 55
- 57: Erdungsanschluß an 20'
- 58: Eckpfosten von 10

## Patentansprüche

1. Verteilerschrank (10) der Kommunikationstechnik mit einer in wenigstens einer Schrankwand (14, 15) vorgesehenen Wandöffnung zum Ein- bzw. Ausführen (16, 17) von Kabeln,
deren Adern im Schrankinneren (11) an Kabelabschluß- oder Rangiermitteln (13) kontaktiert sind,
**dadurch gekennzeichnet,**
daß ein Fenster (42) in der Schrankwand (14) eingeschnitten ist, das sich mindestens über die ganze fakultative Spanne der in verschiedenen Anwendungsfällen des Schrankes (10) erwünschten Lagen der Wandöffnung erstreckt (43),
das Fenster (42) von wenigstens einer beweglichen Platte (20, 20') abgedeckt ist, die Schrankwand (14) Führungen (30) trägt zur Verstellung (22, 22') der Platte (20, 20') in einer Parallelebene (34, 34') zur Schrankwand (14)
und die Platte (20, 20'), entsprechend dem Ausmaß ihrer Verstellung in der Führung (30), mit dem Fenster (42) eine hinsichtlich ihrer Lage und/oder ihrer Öffnungsweite (41) variable Wandöffnung (40) in der Schrankwand (14) erzeugt.

2. Schrank nach Anspruch 1, dadurch gekennzeichnet, daß zur Schubverstellung (22, 22') der Platte bzw. der Platten (20, 20') an der Schrankwand die Führungen (30) als Längsführungen (30) angeordnet sind, die parallel zur Fensterlänge (43) des Fensters (42) verlaufen.

3. Schrank nach Anspruch 1 oder 2, dadurch gekennzeichnet, daß zwei Platten (20, 20'), die benachbarte Fensterbereiche überdecken, in zueinander höhenversetzten Parallelebenen (34, 34') liegen, zwar voneinander unabhängig, aber miteinander abgestimmt verstellbar (22, 22') sind und mit dementsprechend variablen Überlappungsabschnitten (28) einander überlappen.

4. Schrank nach Anspruch 3, dadurch gekennzeichnet, daß benachbarte Platten (20, 20') an den im Überlappungsabschnitt (28) befindlichen Endkanten wenigstens stellenweise zueinander gegensinnig abgewinkelte Endflansche (24, 24') aufweisen und die beiden Endflansche (24, 24') bei aufeinander zu gerichteter Verstellung der Platten (20, 20') sich zwar voneinander entfernen, aber bei gegensinniger Verstellung schließlich als Anschlag sowie, bei weiterer Verstellung, als Mitnehmer der Platten dienen.

5. Schrank nach einem oder mehreren der Ansprüche 1 bis 4, dadurch gekennzeichnet, daß zwei Platten (20'), die benachbarte Fensterbereiche überdecken, in der gleichen Plattenebene (34') liegen und mit ihren einander zugekehrten Stoßkanten (29) einander berühren.

6. Schrank nach Anspruch 5, dadurch gekennzeichnet, daß die benachbarten Platten (20') mit ihren Stoßkanten (29) wahlweise voneinander weg verstellbar (22') sind, um zwischen sich eine Wandöffnung zu erzeugen.

7. Schrank nach Anspruch 5 oder 6, dadurch gekennzeichnet, daß die Platten (20') an ihren Stoßkanten (29) wahlweise zu einer gemeinsamen Kombinationsplatte miteinander kuppelbar (45) sind.

8. Schrank nach Anspruch 7, dadurch gekennzeichnet, daß die einander zugekehrten Stoßkanten (29) benachbarter Platten (20') wenigstens stellenweise jeweils einen zueinander gleichsinnig abgewinkelten Endflansch (24') aufweisen und die beiden Endflansche (24') im Kupplungsfall mit einem lösbaren Verbinder (45) versehen sind.

9. Schrank nach Anspruch 8, dadurch gekennzeichnet, daß der Verbinder aus einem elastischen Einfaßsteg (45) besteht, der im Kupplungsfall die Kantenstreifen (39) der beiden Endflansche (24') übergreift.

10. Schrank nach einem oder mehreren der Ansprüche 1 bis 9, dadurch gekennzeichnet, daß die Längsführungen aus zwei U-Profilschienen (30) bestehen, welche das Fenster (42) zwischen sich schließen und zur Gleitführung von Randzonen (21, 21') einer Schar von in einer Reihe angeordneten Platten (20, 20') dienen, die alle zueinander gleichförmig ausgebildet sind.

11. Schrank nach einem oder mehreren der Ansprüche 1 bis 10, dadurch gekennzeichnet, daß die Platten (20, 20') in sich U-förmig verkröpft sind und ihre beiden abgewinkelten Endstücke die Endflansche (24, 24') bilden.

12. Schrank nach einem oder mehreren der Ansprüche 4 bis 11, dadurch gekennzeichnet, daß der Kantenstreifen mindestens des äußeren Endflansches (24, 24') der letzten Platte (20, 20') mit einem als Kantenschutz dienenden Einfaßsteg (44) verkleidet ist.

13. Schrank nach einem oder mehreren der Ansprüche 10 bis 12, dadurch gekennzeichnet, daß die Randzonen (21, 21') der verkröpften Platten (20, 20') im Bereich der Endflansche (24, 24') mit Ausschnitten (25, 25') versehen sind und die Platten (20, 20') im Ausschnittbereich (26, 26') an der Stirnkante (36) des einen Schienenschenkels (32) der U-Profilschiene (30) längsgeführt sind.

14. Schrank nach einem oder mehreren der Ansprüche 10 bis 13, dadurch gekennzeichnet, daß die beiden Schienenschenkel (32, 33) der U-Profilschiene (30) eine zueinander unterschiedliche Schenkellänge aufweisen, wobei der kürzere Schienenschenkel (32) der Schrankwand (14) zugekehrt ist und zur Führung (26, 36; 26', 30) der Platten (20, 20') dient, während der lange Schienenschenkel (33) diese Führungen schauseitig abdeckt.

15. Schrank nach einem oder mehreren der Ansprüche 10 bis 14, dadurch gekennzeichnet, daß bei derjenigen verkröpften Platte (20), deren beide Endschenkel (24) gegen die Schrankwand (14) weisen, die zwischen den endflanschseitigen Ausschnitten verbleibenden Lappen (27) der Randzone (21) ins Schieneninnere (31) der U-Profilschiene (30) eingreifen.

16. Schrank nach einem oder mehreren der Ansprüche 10 bis 14, dadurch gekennzeichnet, daß die U-Profilschiene (30) über einen Abstandhalter (37, 50) an der Schrankwand (14) befestigt ist und mit ihrem unteren Schienenschenkel eine Lücke (38) mit der Schrankwand (14) einschließt, in welche die zwischen den Ausschnitten (27') verbleibenden Lappen (27') der Randzonen (21') derjenigen verkröpften Platten (20') eingreifen, deren beide Endflansche (24') von der Schrankwand (14) weggerichtet sind.

17. Schrank nach Anspruch 16, dadurch gekennzeichnet, daß die Abstandhalter (50) zugleich zur Befestigung der U-Profilschiene (30) an der Schrankwand (14) dienen.

18. Schrank nach Anspruch 17, dadurch gekennzeichnet, daß der Abstandhalter aus einem mit einem endseitigen Bund (52) versehenen Spreizdübel (50) besteht, der mit seinen Spreizteilen (51) Löcher (46) in der Schrankwand (14) hintergreift und von einer vorzugsweise nur am unteren Schienenschenkel (32) mit ihrem Schraubkopf anliegenden Schraube (53) spreizbefestigbar ist, wobei der Bund (52) des Spreizdübels (50) die Lücke (38) zwischen der U-Profilschiene (30) und der Schrankwand (14) bestimmt.

19. Schrank nach einem oder mehreren der Ansprüche 1 bis 18, dadurch gekennzeichnet, daß die Randzonen (21, 21') der verkröpften Platte (20, 20') im mittleren Bereich mit wenigstens einem Ausbruch (55) versehen sind, dessen Ausbruchsende (56) anschlagartig mit einem Halter der U-Profilschiene (30), wie ihrem Abstandhalter (50), zusammenwirkt und den maximalen Verstell-Weg (22') der Platte (20') begrenzt.

20. Schrank nach einem oder mehreren der Ansprüche 1 bis 19, dadurch gekennzeichnet, daß die Schrankwand (14) im Randbereich (49) des Fensters (42) mit einer umlaufenden Flachdichtung (54) versehen ist, auf welcher die Platten (20') aufliegen.

21. Schrank nach einem oder mehreren der Ansprüche 1 bis 20, dadurch gekennzeichnet, daß die Platten (20') auf ihrer dem Fenster (42) zugekehrten Innenfläche mit Erdungsanschlüssen (57) versehen sind, an welchen ein zwischen den Platten (20, 20') flexibel verlaufendes Erdverbindungskabel kontaktiert ist.

22. Schrank nach einem oder mehreren der Ansprüche 1 bis 21, dadurch gekennzeichnet, daß die Platten (20, 20') und ihre Führungen (30) auf der Außenseite (18) einer deckenseitigen Wand (14) des Schrankes (10) bzw. auf der Innenseite (19) der bodenseitigen Wand (15) des Schrankes (10) angeordnet sind.

23. Schrank nach einem oder mehreren der Ansprüche 1 bis 22, dadurch gekennzeichnet, daß die verkröpften formgleichen Platten (20, 20') in Abhängigkeit von der gewünschten Lage der Wandöffnung (40) entweder in der gleichen Ebene (34') nebeneinander oder aber die eine Platte (20) in gewendeter Position zu der anderen (20') in übereinanderliegenden Ebenen (34, 34') an den U-Profilschienen (30) montiert werden können.

## Claims

1. A distribution cabinet (10) in communications technology having a wall opening in at least one cabinet wall (14, 15) for leading in and out (16, 17) cables whose wires are contacted in the cabinet interior (11) to cable termination or plug connection means (13),
characterised in that
a window (42) is cut in the cabinet wall (14), which window extends (43) at least over the entire optional span of the positions of the wall opening which are desired in different situations of use of the cabinet (10),
the window (42) is covered by at least one movable plate (20, 20'), the cabinet wall (14) carries guides (30) for displacement (22, 22') of the plate (20, 20') in a parallel plane (34, 34') relative to the cabinet wall (14), and
the plate (20, 20'), in accordance with the extent of its displacement in the guide (30), produces with the window (42) a wall opening (40) in the cabinet wall (14), which opening is variable in respect of its position and/or its width (41).

2. A cabinet according to claim 1 characterised in that the guides (30) are arranged as longitudinal guides (30) for pushing displacement (22, 22') of the plate or plates (20, 20') on the cabinet wall, the longitudinal guides extending parallel to the length (43) of the window (42).

3. A cabinet according to claim 1 or claim 2 characterised in that two plates (20, 20') which cover over adjacent window regions lie in parallel planes (34, 34') which are displaced in respect of height relative to each other, and are displaceable (22, 22') admittedly independently of each other but synchronised with each other, and overlap each other with correspondingly variable overlap portions (28).

4. A cabinet according to claim 3 characterised in that adjacent plates (20, 20') have end flanges (24, 24') which are angled in mutually opposite directions at least at a place-wise manner at the end edges in the overlap portion (28) and the two end flanges (24, 24') move away from each other upon displacement of the plates (20, 20') towards each other but upon displacement in opposite directions finally serve as abutment means and upon further displacement as entrainment means for the plates.

5. A cabinet according to one or more of claims 1 to 4 characterised in that two plates (20') which cover over adjacent window regions lie in the same plate plane (34') and are in contact with each other with their mutually facing butt edges (29).

6. A cabinet according to claim 5 characterised in that the adjacent plates (20') are selectively displaceable (22') away from each other with their butt edges (29) in order to produce a wall opening between them.

7. A cabinet according to claim 5 or claim 6 characterised in that the plates (20') can be selectively coupled (45) together at their butt edges (29) to form a common combination plate.

8. A cabinet according to claim 7 characterised in that at least in a place-wise manner the mutually facing butt edges (29) of adjacent plates (20') each have an end flange (24'), the end flanges being angled in the same direction relative to each other, and the two end flanges (24') are provided with a releasable connector (45) in the coupled condition.

9. A cabinet according to claim 8 characterised in that the connector comprises an elastic binding bar (45) which in the coupled condition engages over the edge strips (39) of the two end flanges (24').

10. A cabinet according to one or more of claims 1 to 9 characterised in that the longitudinal guides comprise two U-shaped rails (30) which enclose the window (42) between them and serve for slidingly guiding edge zones (21, 21') of an assembly of plates (20, 20') which are arranged in a row and which are all of the same configuration as each other.

11. A cabinet according to one or more of claims 1 to 10 characterised in that the plates (20, 20') are bent in a U-shape in themselves and their two angled end portions form the end flanges (24, 24').

12. A cabinet according to one or more of claims 4 to 11 characterised in that the edge strip at least of the outer end flange (24, 24') of the last plate (20, 20') is clad with a trim bar (44) serving as an edge protection means.

13. A cabinet according to one or more of claims 10 to 12 characterised in that the edge zones (21, 21') of the bent plates (20, 20') are provided with cut-outs (25, 25') in the region of the end flanges (24, 24') and the plates are longitudinally guided in the cutout region (26, 26') at the end edge (36) of the one limb (32) of the U-shaped rail (30).

14. A cabinet according to one or more of claims 10 to 13 characterised in that the two limbs (32, 33) of the U-shaped rail (30) are of lengths which are different from each other, wherein the shorter rail limb (32) is towards the cabinet wall (14) and serves to guide (26, 36; 26', 30) the plates (20, 20') while the long rail limb (33) covers said guides on the visible side.

15. A cabinet according to one or more of claims 10 to 14 characterised in that in that bent plate (20) whose two end limbs (24) face towards the cabinet wall (14), the tongue portions (27) of the edge zone (21), which remain between the cut-outs at the end flange side, engage into the interior (31) of the U-shaped rail (30).

16. A cabinet according to one or more of claims 10 to 14 characterised in that the U-shaped rail (30) is fixed to the cabinet wall (14) by way of a spacer (37, 50) and with its lower rail limb defines relative to the cabinet wall (14) a gap (38) into which engage the tongue portions (27), that remain between the cut-outs (27'), of the edge zones (21') of those bent plates (20') whose two end flanges (24') are directed away from the cabinet wall (14).

17. A cabinet according to claim 16 characterised in that the spacers (50) serve at the same time for fixing the U-shaped rail (30) to the cabinet wall (14).

18. A cabinet according to claim 17 characterised in that the spacer comprises an expansible dowel (50) which is provided with a collar (52) at its end and which engages with its expansion portions (51) behind holes (46) in the cabinet wall (14) and can be expansibly secured in position by a screw (53) which bears with its screw head preferably only against the lower rail limb (32), wherein the collar (52) of the expansible dowel (50) defines the gap (38) between the U-shaped rail (30) and the cabinet wall (14).

19. A cabinet according to one or more of claims 1 to 18 characterised in that the edge zones (21, 21') of the bent plate (20, 20') are provided in the middle region with at least one recess (55) whose end (56) co-operates abutment-like with a holder of the U-shaped rail (30) like its spacer (50), and defines the maximum displacement travel (22') of the plate (20').

20. A cabinet according to one or more of claims 1 to 19 characterised in that in the edge region (49) of the window (42) the cabinet wall (14) is provided with a flat seal (54) which extends around the window and against which the plates (20') bear.

21. A cabinet according to one or more of claims 1 to 20 characterised in that on their inside surfaces which are towards the window (42) the plates (20') are provided with earthing connections (57) at which an earth connection cable extending flexibly between the plates (20, 20') is contacted.

22. A cabinet according to one or more of claims 1 to 21 characterised in that the plates (20, 20') and their guides (30) are arranged on the outside (18) of a top wall (14) of the cabinet (10) or on the inside (19) of the bottom wall (15) of the cabinet (10).

23. A cabinet according to one or more of claims 1 to 22 characterised in that, depending on the desired position for the wall opening (40), either the bent plates (20, 20') of the same shape can be mounted in the same plane (34') in juxtaposed relationship or the one plate (20) can be mounted in an inverted position relative to the other plate (20') in superposed planes (34, 34'), on the U-shaped rails (30).

## Revendications

1. Armoire de distribution (10) de la technique de communication, comportant une ouverture prévue dans au moins une paroi (14,15) de l'armoire pour l'introduction et la sortie (16,17) de câbles,
dont les conducteurs sont, dans l'espace intérieur (11) de l'armoire, placés en contact avec des moyens de terminaison ou de rangement des câbles,
caractérisée en ce
que dans la paroi (14) de l'armoire est découpée une fenêtre (42), qui s'étend (43) au moins sur toute la portée facultative des positions d'ouverture de paroi, désirées dans différents cas d'utilisation de l'armoire (10),
que la fenêtre (42) est fermée par au moins une plaque mobile (20,20'), et que la paroi (14) de l'armoire porte des guides (30) servant à déplacer (22,22') la plaque (20, 20') dans un plan (34,34') parallèle à la paroi (14) de l'armoire, et
qu'en fonction de sa distance de déplacement dans le guide (30), la plaque (20,20') définit avec la fenêtre (42), dans la paroi (14) de l'armoire, une ouverture de paroi (40) dont la position et/ou l'étendue (41) sont variables.

2. Armoire selon la revendication 1, caractérisée en ce que pour le déplacement par poussée (22,22') de la plaque ou des plaques (20,20'), des guides (30) sont disposés sur la paroi de l'armoire sous la forme de guides longitudinaux (30), qui sont parallèles à l'étendue en longueur (43) de la plaque (42).

3. Armoire selon la revendication 1 ou 2, caractérisée en ce que deux plaques (20,20'), qui recouvrent des parties voisines de la fenêtre, sont situées dans des plans parallèles (34,34') décalés en hauteur l'un par rapport à l'autre, sont déplaçables (22,22') en général indépendamment l'une de l'autre, mais en étant réglées l'une sur l'autre, et se chevauchent réciproquement avec des sections de chevauchement variables correspondantes (28)

4. Armoire selon la revendication 3, caractérisée en ce que des plaques voisines (20,20') comportent des brides d'extrémité (24,24') repliées en des sens réciproquement opposés, au moins par endroits, au niveau des bords d'extrémité situés dans la section de chevauchement (28), et que lors d'un déplacement des plaques (20, 20') l'une vers l'autre, des deux brides d'extrémité (24, 24') s'éloignent l'une de l'autre, alors que dans le cas d'un déplacement en sens opposé, les deux brides d'extrémité sont utilisées finalement en tant que butée ainsi que, dans le cas de la poursuite du déplacement, en tant qu'organes d'entraînement des plaques.

5. Armoire selon une ou plusieurs des revendications 1 à 4, caractérisée en ce que deux plaques (20'), qui recouvrent des parties voisines de la fenêtre, sont situées dans le même plan (34') et se touchent par leurs bords d'aboutement (29), qui se font face.

6. Armoire selon la revendication 5, caractérisée en ce que les plaques voisines (20') peuvent être au choix écartées l'une de l'autre (22') par leurs bords d'aboutement (29), de manière à former entre elles une ouverture de la paroi.

7. Armoire selon la revendication 5 ou 6, caractérisée en ce que les plaques (20') peuvent être accouplées au choix (45), au niveau de leurs bords d'aboutement (29), pour former une plaque combinée commune.

8. Armoire selon la revendication 7, caractérisée en ce que les bords d'aboutement (29), qui sont tournés l'un vers l'autre, de plaques voisines (20') possèdent au moins par endroits des brides d'extrémité respectives (24') repliées dans le même sens et que les deux brides d'extrémité (24') comportent, dans le cas d'un accouplement, un connecteur amovible (45).

9. Armoire selon la revendication 8, caractérisée en ce que le connecteur est constitué par une barrette élastique d'insertion (45), qui, dans le cas de l'accouplement, s'engage par-dessus les bandes d'arête (39) des deux brides d'extrémité (24').

10. Armoire selon une ou plusieurs des revendications 1 à 9, caractérisée en ce que les guides longitudinaux sont constitués de deux rails profilés en U (30), qui enserrent entre eux la fenêtre (42) et sont utilisés pour le guidage coulissant de zones marginales (21, 21') d'un ensemble de plaques (20,20') disposées suivant une rangée et qui sont toutes agencées avec la même forme.

11. Armoire selon une ou plusieurs des revendications 1 à 10, caractérisée en ce que les plaques (20,21) sont repliées sur elles-mêmes en forme de U et que leurs deux parties d'extrémité coudées forment les brides d'extrémité (24,24').

12. Armoire selon l'une des revendications 4 à 11, caractérisée en ce que la bande d'arête au moins de la bride d'extrémité extérieure (24,24') de la dernière plaque (20,20') est habillée par une barrette d'encadrement (44) utilisée comme dispositif de protection d'arête.

13. Armoire selon une ou plusieurs des revendications 10 à 12, caractérisée en ce que les zones marginales (21,21') des plaques coudées (20,21) comportent des- découpes (25,25') au niveau des brides d'extrémité (24, 24') et que les plaques (20,20') sont guidées longitudinalement, dans la zone (26,26') de la découpe, sur le bord frontal (36) d'une branche (32) du rail profilé en U (30).

14. Armoire selon une ou plusieurs des revendications 10 à 13, caractérisée en ce que les deux branches (32,33) du rail profilé en U (30) possèdent des longueurs différentes, la branche la plus courte (32) du rail étant tournée vers la paroi (14) de l'armoire et servant au guidage (26,36; 26',30) des plaques (20,20'), tandis que la branche longue (33) du rail recouvre ces guides, sur le côté visible.

15. Armoire selon une ou plusieurs des revendications 10 à 14, caractérisée en ce que dans le cas de la plaque coudée (20), dont les deux branches d'extrémité (24) sont dirigées vers la paroi (14) de l'armoire, les pattes (27) de la zone marginale (21), qui subsistent entre les découpes situées dans les brides d'extrémité, s'engagent à l'intérieur (31) du rail profilé en U (30).

16. Armoire selon une ou plusieurs des revendications 10 à 14, caractérisée en ce que le rail profilé en U (30) est fixé par l'intermédiaire d'une entretoise (37,50) à la paroi (14) de l'armoire et sa branche inférieure délimite par rapport à la paroi (14) de l'armoire, un espace vide (38), dans lequel s'engage des pattes (27') qui subsistent entre des découpes (27'), des zones marginales (21') de la plaque coudée (20'), dont les deux brides d'extrémité (24') sont dirigées à l'opposé de la paroi (14) de l'armoire.

17. Armoire selon la revendication 16 caractérisée en ce que les entretoises (50) servent simultanément à fixer le rail profilé en U (30) à la paroi (14) de l'armoire.

18. Armoire selon la revendication 17, caractérisée en ce que l'entretoise est constituée par une cheville à expansion (50), qui comporte un collet d'extrémité (52) qui s'engage, par ses parties d'écartement (51) dans des trous (46) aménagés dans la paroi (14) de l'armoire et peuvent être fixés en position écartée par une vis (53) qui s'applique par sa tête filetée de préférence uniquement contre la branche inférieure (32) du rail, le collet (52) de la cheville à expansion (50) déterminant un intervalle vide (38) entre le rail profilé en U (30) et la paroi (14) de l'armoire.

19. Armoire selon une ou plusieurs des revendications 1 à 18, caractérisée en ce que les zones marginales (21,21') de la plaque coudée (20,20') comportent, dans la partie médiane, au moins une découpe (55), dont l'extrémité (56) coopère à la manière d'une butée avec un support du rail profilé en U (30), comme par exemple son entretoise (50), et limite le trajet maximum de déplacement (22') de la plaque (20').

20. Armoire selon une ou plusieurs des revendications 1 à 19, caractérisée en ce que la paroi (14) de l'armoire comporte, dans la zone marginale (49) de la fenêtre (42), une garniture d'étanchéité périphérique plate (54), sur laquelle prennent appui les plaques (20').

21. Armoire selon une ou plusieurs des revendications 1 à 20, caractérisée en ce que les plaques (20') comportent, sur leur surface intérieure tournée vers la fenêtre (42), des bornes de raccordement à la terre (57), en contact avec lesquelles est placé un câble de raccordement à la terre, qui s'étend de façon souple entre les plaques (20,20').

22. Armoire selon une ou plusieurs des revendications 1 à 21, caractérisée en ce que les plaques (20,20') et leurs guides (30) sont disposés sur la face extérieure (18) d'une paroi (14), située côté plafond, de l'armoire (10) ou sur la face intérieure (19) de la paroi (15), située du côté du fond, de l'armoire (10).

23. Armoire selon une ou plusieurs des revendications 1 à 22, caractérisée en ce que, en fonction de la position désirée de l'ouverture (40) de la paroi, les plaques coudées de même forme (20,20') peuvent être montées côte-à-côte dans le même plan (34'), ou bien une plaque (20) peut être montée dans une position retournée par rapport à l'autre plaque (20'), les plaques étant moulées dans des plans superposés (34,34') sur les rails profilés en U (30).
